# EUROPÄISCHE PATENTSCHRIFT

(11) **EP 1 258 957 B1**
(45) Veröffentlichungstag und Bekanntmachung des Hinweises auf die Patenterteilung: **20.07.2005**
(21) Anmeldenummer: 02010934.4
(22) Anmeldetag: 16.05.2002
(51) Int. Cl.: H02B 1/052, H02B 1/20

(54) **Schaltgerätesystem**
Switch assembly
Ensemble d'interrupteurs

(30) Priorität: 16.05.2001 EP 01111830
(43) Veröffentlichungstag der Anmeldung: 20.11.2002
(73) Patentinhaber: Gustav Hensel GmbH & Co. KG, 57368 Lennestadt (DE)
(72) Erfinder: Cater, Rudolf, 57392 Schmallenberg (DE); Budde, Gerhard, 57368 Lennestadt (DE)
(74) Vertreter: Stenger, Watzke & Ring Patentanwälte

(56) Entgegenhaltungen:
- EP-A- 1 022 809
- DE-C- 19 605 698
- US-A- 4 558 914
- US-A- 5 716 241

## Beschreibung

Die vorliegende Erfindung betrifft ein Schaltgerätesystem zum zentralen Einbau in einem Schaltschrank bzw. Verteilergehäuse für Elektroinstallationen für im Bereich der Gebäudesystemtechnik an einem Installationsbus betreibbare Sensorik- und/oder Aktorikelemente zum Steuern und Schalten von elektrischen Verbrauchsmitteln.

Da die bisher übliche Gebäudeinstallation lediglich auf die Verteilung und das Schalten von elektrischer Energie ausgerichtet ist und den ständig steigenden Anforderungen hinsichtlich Flexibilität und Komfort von Elektroinstallationen nicht genügt, werden im Bereich der Gebäudesystemtechnik zum Steuern, Regeln, Überwachen und/oder Melden vermehrt Installationsbus-Systeme eingesetzt, die hochflexibel und erweiterungsfähig sind, insbesondere für nachträgliche Änderungen oder Erweiterungen der Funktion innerhalb einer Installation.

Installationsbus-Systeme sind weitestgehend standardisiert, beispielsweise EIB (European Installation Bus), KNX, BACNet, Batibus, Convergence oder dergleichen, und dienen der automatisierten Steuerung betriebsstechnischer Funktionen in Wohn- und Zweckbauten. Das Funktionsprinzip der Installationsbusse, insbesondere des EIB, beruht auf der Signalübertragung zwischen Sensorik- und Aktorikelementen die zu verschiedenen Verbrauchsmitteln, d.h. Geräten und Anlagen in den Wohn- oder Zweckbauten, gehören.

Im Gegensatz zur herkömmlichen Elektroinstallation, bei der jede zu realisierende Funktion eigene Energieversorgungs- und Steuerungssystemleitungen benötigt, beispielsweise in Beleuchtungsanlagen, Heizanlagen, Alarmanlagen und dergleichen, werden Verbrauchsmittel, das heißt Endgeräte wie Leuchten, Heizungen, Alarmmelder und dergleichen, mittels Sensorik- und/oder Aktorikelementen über einen Installationsbus gesteuert.

Die Verbindung zwischen den installationsbusfähigen Verbrauchsmitteln sowie den Sensorik- und/oder Aktorikelementen erfolgt in für Elektroinstallationen gebräuchlichen Schaltschränken bzw. Verteilergehäusen, in welchen Leitungen für den Installationsbus und Energieversorgungsleitungen für die Schaltgeräte und Sensorik- und/oder Aktorikelemente zentral zugeführt werden. Die Schaltschränke bzw. Verteilergehäuse weisen Einbaureihen auf, in welchen die Schaltgeräte angeordnet werden, wobei die Sensorik- und/oder Aktorikelemente über Datenschienen bzw. konventionelle Verdrahtung an den Installationsbus angeschlossen und über Sicherungseinrichtungen mit Energieversorgungsleitungen für die Verbrauchsmittel verbunden werden. Darüber hinaus werden die Schaltgeräte sowie die Sensorik- und/oder Aktorikelemente im Schaltschrank bzw. Verteilergehäuse über eine konventionelle Verdrahtung untereinander und mit zum Anschluss der Verbrauchsmittel im Schaltschrank bzw. Verteilergehäuse separat vorgesehenen Anschlussklemmen verbunden.

Die bisher in Schaltschränken bzw. Verteilergehäusen angeordneten Schaltgeräte für an einem Installationsbus betreibbare Sensorik- und/oder Aktorikelemente zum Steuern von elektrischen Verbrauchsmitteln weisen damit einen erheblichen Verdrahtungsaufwand auf, verbunden mit der Möglichkeit von Verdrahtungsfehlem bei der Montage. Darüber hinaus können die in den zur Befestigung von Schaltgeräten sowie Sensorik- und/oder Aktorikelementen dienenden Hutprofilschienen eingebrachten Datenschienen, sofern diese nicht mit Geräten überbaut oder mit einer Abdeckung versehen werden, verschmutzen oder durch den Aufbau hierfür nicht geeigneter Geräte zerstört werden.

Weiter weisen die bisher eingesetzten Sensorik- und/oder Aktorikelemente eine relativ große Bauform auf, die zum einen durch die verschiedenen Klemmen für die Verdrahtung der Sensorik- und/oder Aktorikelemente untereinander, mit der Energieversorgungseinrichtung für die Verbrauchsmittel sowie den Abgangsklemmen im Klemmraum des Schaltschrankes für die Verbrauchsmittel und zum anderen durch die in den Sensorik- und/oder Aktorikelementen jeweils vorhandene Busanschlußeinrichtung gegeben ist. Die relativ große Bauform der Sensorik- und/oder Aktorikelemente und die aufwendige Verdrahtung bedingt, dass in den Schaltschränken bzw. Verteilergehäusen ein relativ großer Platzbedarf hierfür notwendig ist.

Eine Erweitung einer an einem Installationsbus betreibbare Sensorik- und/oder Aktorikelemente zum Steuern von elektrischen Verbrauchsmitteln einsetzenden Gebäudeinstallation ist so nur beschränkt möglich, nicht zuletzt da die Sensorik- und/oder Aktorikelemente jeweils eine eigene, nicht bzw. nahezu nicht erweiterbare Busanschlußeinrichtung umfassen.

Aus der EP 0 790 541 A2 ist ein Schaltgerätesystem für im Bereich der Gebäudesystemtechnik an einem Installationsbus betreibbare Sensorik- und/oder Aktorikelemente zum Steuern und Schalten von elektrischen Verbrauchsmitteln bekannt. Das aus der EP 0 790 541 A2 bekannte Schaltgerätesystem ist für einen dezentralen Einsatz ausgebildet, wobei die einzelnen Sensorik- und/oder Aktorikelemente des Schaltgerätesytems ausschließlich über vorkonfektionierte Leitungen mittels Steckverbinder angeschlossen werden. Nachteilig ist bei dem Schaltgerätesystem gemäß der EP 0 790 541 A2 des weiteren, dass bedingt durch dezentrale Anordnung der Sensorik- und/oder Aktorikelemente sowohl bei einer Neuinstallation als auch bei nachträglich vorzunehmenden Änderungen einer Gebäudeinstallation Sensorik- und/oder Aktorikelemente, welche beispielsweise in Decken, Doppelböden oder dergleichen platziert sind oder platziert werden, nur schwer lokalisierbar und aufwendig austausch- und konfigurierbar sind. Dadurch ist die Modularität des Schaltgerätesystems gemäß der EP 0 790 541 A2 eingeschränkt.

Die US 5,716,241 beschreibt Funktionsmodule, die auf handelsüblichen Tragschienen aufrastbar sind und die als Reihenklemmen mit eingebauter Eingangs-/Ausgangs-Elektronik ausgeführt sind. Hierdurch wird ein Klemmenbus gebildet, bei dem die in die Busklemmen integrierten Datenbusleitungen, Stromversorungsleitungen und auch Leistungsstromversorgung für die Module beim Aufrasten auf die Tragschiene durchkontaktiert bzw. durchgeschleift sind.

Die EP 1 022 809 A2 beschreibt ein elektrisches Gerät mit einem modularen Aufbau, welches ein auf eine Tragschiene aufsetzbares Anschlußmodul aufweist, daß mit Anschlußebenen aus Doppel- und/oder Mehrfachanschlüssen versehen ist und eine Aneinanderreihung aus scheibenförmigen Basis-Klemmenträgern aufweist. An den Klemmenträgern sind mehrere Potentialführungen vorgesehen, die über Stromschienen der scheibenförmigen Basis-Klemmenträger mit den Anschlußebenen verbunden sind.

Der Erfindung liegt in Anbetracht dieses Standes der Technik die **Aufgabe** zugrunde, ein Schaltgerätesystem der eingangs genannten Art bereitzustellen, welches die beschriebenen Nachteile vermeidet und dabei eine verbesserte und vereinfachte Modularität hinsichtlich der Anwendung des Schaltgerätesystems aufweist, insbesondere hinsichtlich möglicher Veränderungen und/oder Erweiterungen einer Gebäudeinstallation.

Zur technischen **Lösung** dieser Aufgabe wird mit der Erfindung ein Schaltgerätesystem zum zentralen Einbau in einem Schaltschrank bzw. Verteilergehäuse für Elektroinstallationen für im Bereich der Gebäudesystemtechnik an einem Installationsbus betreibbare Sensorik- und/oder Aktorikelemente zum Steuern von elektrischen Verbrauchsmitteln vorgeschlagen, mit einem eine (Busanschlußeinrichtung) BCU und einen ein Bussystem bereitstellenden Ausgang aufweisenden Basismodul zur Parametrisierung von Funktionsmodulen und wenigstens einem einen Installationsbusanschluss zur Kommunikation mit Sensorik- und/oder Aktorikelementen und zur Energieversorgung der Sensorik- und/oder Aktorikelemente, einen eingangsseitigen und wenigstens einen ausgangsseitigen Energieversorgungsanschluss zur Energieversorgung von zu steuernden elektrischen Verbrauchsmitteln, wenigstens einen Schaltkontakt zum Verbinden oder Trennen des eingangsseitigen und wenigstens eines ausgangsseitigen Energieversorgungsanschlusses und einen Eingang und einen Ausgang für das vom Basismodul bereitgestellte Bussystem aufweisenden Funktionsmodul, wobei das Basismodul und das wenigstens eine Funktionsmodul über das Bussystem miteinander kommunizieren und Ausgang und Eingang des Bussystems der Module ein Stecksystem zum lösbaren Verbinden der Module zu einer Einheit bereitstellen und wobei die Funktionsmodule über das interne Bussystem von dem Basismodul automatisch adressiert werden.

Erfindungsgemäß wird die Einrichtung zur Steuerung von Sensorik- und/oder Aktorikelementen durch eine Busanschlußeinrichtung seitens des Basismoduls bereitgestellt, während die Schaltkontakte seitens der Funktionsmodule angeordnet sind. Über das Bussystem lassen sich die Funktionsmodule von der vorzugsweise (Busanschlußeinrichtung)_BCU des Basismoduls im Rahmen der Parametrisierung steuern. Dazu ist die (Busanschlußeinrichtung) BCU im Basismodul entsprechend den gewünschten Applikationen programmierbar, vorzugsweise mittels einer über eine weitere Schnittstelle seitens des Basismoduls anschließbare Eingabeeinrichtung, beispielsweise eine tragbare Recheneinrichtung wie ein Laptop oder dergleichen. Das Schaltgerätesystem ist so durch Anschluss weiterer Funktionsmodule an das Bussystem beliebig erweiterbar. Erfindungsgemäß ist das Bussystem schaltungstechnischer Bestandteil des Stecksystems, welches eine lösbar mechanische Verbindung von Funktionsmodulen untereinander und einem Funktionsmodul mit dem Basismodul bereitstellt. Die die Schaltkontakte umfassenden Funktionsmodule des erfindungsgemäßen Schaltgerätesystems sind dem die Busanschlußeinrichtung zur Steuerung der Sensorik- und/oder Aktorikelemente aufweisenden Basismodul untergeordnet und benötigen so selbst keine Busanschlußeinrichtung zur Parametrisierung über das Bussystem. Dadurch sind die baulichen Abmessungen der einzelnen Funktionsmodule und damit des gesamten Schaltgerätesystems gegenüber den bisher bekannten Lösungen erheblich reduziert. So lassen sich auf gleichem Raum in Schaltschränken mehr Sensorik- und/oder Aktorikelemente anordnen. Darüber hinaus ist die Fertigung von Modulen vereinfacht.

Enfindungsgemäß werden die Funktionsmodule über das Bussystem von dem Basismodul automatisiert hinsichtlich ihrer Schaltkontakte und deren Applikation erkannt, beispielsweise über eine sogenannte Widerstandscodierung. Gemäß einer weiteren vorteilhaften Ausgestaltung der Erfindung ist das Steckersystem mit einer Codierung versehen, so dass anhand des codierten Steckersystems eine automatisierte Erkennung der Funktionsmodule gegeben ist.

In einer weiteren vorteilhaften Ausgestaltung der Erfindung weist das Funktionsmodul einen Mikrocontroller zur Funktionsrealisierung des Schaltkontakts und zur Steuerung der Kommunikation mit dem Basismodul über das Bussystem sowie mit zugeordneten Sensorik- und/oder Aktorikelementen über den Installationsbus auf. Vorteilhafterweise ermöglichen die Mikrocontroller seitens der Funktionsmodule eine automatische Adressierung der Funktionsmodule seitens des Basismoduls über ein Applikationsprogramm des Mikrocontrollers, wobei über das Bussystem eine Rückmeldung von Adresse und Funktion zwischen Funktionsmodul und Basismodul sichergestellt wird. Darüber hinaus ist es hierdurch ermöglicht, eine Veränderung oder Ergänzung der Funktionsmodule in der Einbauposition bezüglich des Basismoduls vorzunehmen, ohne eine Veränderung der Adressierung seitens der Funktionsmodule vornehmen zu müssen, wie es beispielsweise bei dem Schaltgerätsystem gemäß der EP 0 790 541 A2 bei Positionsveränderungen oder Ergänzungen der Fall ist.

In einer konkreten Ausgestaltung der Erfindung sind bis zu zehn Funktionsmodule an das Basismodul anreihbar.

In einer vorteilhaften Ausgestaltung der Erfindung sind die Energieversorgungsanschlüsse der Erweiterungsmodule als integrierte Anschlussklemmen ausgebildet, vorteilhafterweise mit trennbaren Anschlussklemmen für den Neutralleiter (N). Vorteilhafterweise sind die Anschlussklemmen für Leiterquerschnitte bis 2,5 mm² ausgelegt.

In einer besonders vorteilhaften Ausgestaltung der Erfindung erfolgt die eingangsseitige Energieversorgung der Funktionsmodule über steckbare und voneinander isolierte Stromschienen. Dadurch wird der Verdrahtungsaufwand innerhalb der Schaltschränke bei Verwendung des erfindungsgemäßen Schaltgerätesystems auf ein Minimum reduziert. Darüber hinaus lassen sich bei Verwendung von Stecksystemen für die Energieversorgungsanschlüsse die baulichen Abmessungen durch Fortfall der Anschlussklemmen weiter reduzieren.

Weitere Einzelheiten, Merkmale und Vorteile der Erfindung werden nachfolgend anhand des in Figuren dargestellten Ausführungsbeispiels näher erläutert. Dabei zeigen:
- Figur 1: in einer schematisch perspektivischen Ansicht ein Schaltgerätesystem gemäß der vorliegenden Erfindung;
- Figur 2: in einer schematisch perspektivischen Ansicht Funktionsmodule gemäß der vorliegenden Erfindung;
- Figur 3: in einer weiteren schematisch perspektivischen Ansicht Funktionsmodule gemäß der vorliegenden Erfindung und
- Figur 4: in einer weiteren schematisch perspektivischen Ansicht Funktionsmodule gemäß der vorliegenden Erfindung.

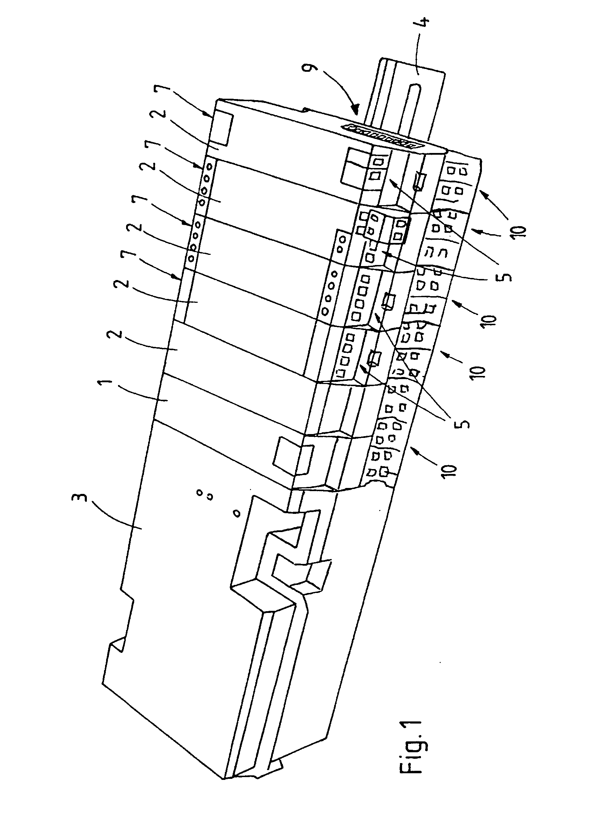

Figur 1 zeigt ein Schaltgerätesystem für im Bereich der Gebäudesystemtechnik an einem Installationsbus betreibbare Sensorik- und/oder Aktorikelemente zum Steuern von elektrischen Verbrauchsmitteln. Das Schaltgerätesystem besteht aus einem Spannungsversorgungsmodul 3, einem Basismodul 1 und mehreren Funktionsmodulen 2, welche verschiedene Funktionalitäten aufweisen, wie in Figur 1 anhand der unterschiedlichen Ausgestaltungen der Funktionsmodule 2 dargestellt.

Das Basismodul 1 weist eine (Busanschlußeinrichtung) BCU und einen ein Bussystem bereitstellenden Ausgang 9 auf, an welchem Funktionsmodule 2 anschließbar sind. Die Funktionsmodule 2 sind dem Basismodul 1 untergeordnet und werden in Abhängigkeit ihrer Funktionalitäten seitens des Mikrocontrollers in ihren Applikationen bestimmt und parametrisiert. Das Spannungsversorgungsmodul 3 gemäß Figur 1 dient zur Gleichspannungsversorgung der Buslinie und der daran angeschlossenen Basismodule. Dabei werden die Funktionsmodule 2 über die integrierten Verbindungen von dem Basismodul 1 mit galvanisch getrennter Gleichspannung versorgt, die zusätzlich unverdrosselt aus dem Spannungsversorgungsmodul 3 zur Verfügung gestellt wird.

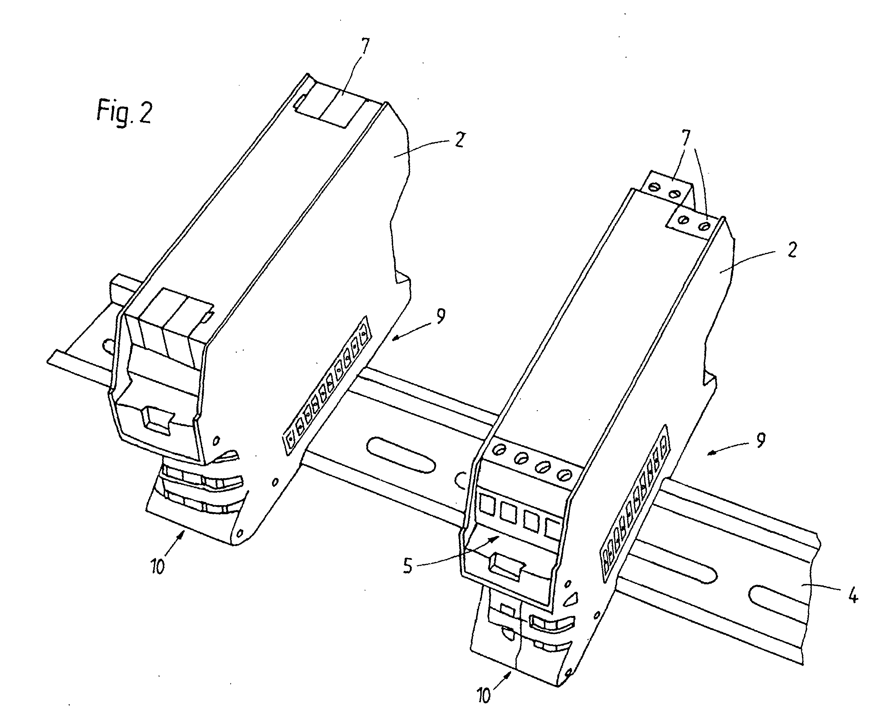

Die Funktionsmodule 2 sind, wie in Figur 2 zu erkennen, auf einer DIN-Hutprofilschiene 4 angeordnet, auf welcher das gesamte Schaltgerätesystem aufgerastet wird. Die DIN-Hutprofilschiene 4 ist in Figur 2 dargestellt und in Schaltschränken bzw. Verteilergehäusen installiert. Weiter weisen die Funktionsmodule 2, wie anhand der Figuren 1 bis 4 zu erkennen, einen eingangsseitigen Energieversorgungsanschluss 5 und wenigstens einen ausgangsseitigen Energieversorgungsanschluss 7 zur Energieversorgung von zu steuernden elektrischen Verbrauchsmitteln auf. Die Eingänge 5 und die Ausgänge 7 der Energieversorgung sind dabei an einander gegenüberliegenden Seiten des Gehäuses eines Funktionsmoduls 2 angeordnet und dabei über eine Platine mit der Mikroelektronik des Sensorik- und/oder Aktorikelementes verbunden.

Die Funktionsmodule 2 weisen in Abhängigkeit ihrer Funktionalität verschiedene Schaltkontakte zum Verbinden bzw. Trennen der eingangsseitigen und ausgangsseitigen Energieversorgungsanschlüsse 5 und 7 auf, beispielsweise Schaltkontakte zur Verwendung in Beleuchtungsanlagen, Heizanlagen, Alarmanlagen oder Jalousiensteuerung. Zur Funktionsrealisierung des Schaltkontakts und zur Steuerung der Kommunikation mit dem Basismodul über das Bussystem sowie mit zugeordneten Sensorik- und/oder Aktorikelementen über den Installationsbus weist das Funktionsmodul einen hier nicht explizit dargestellten Mikrocontroller auf.

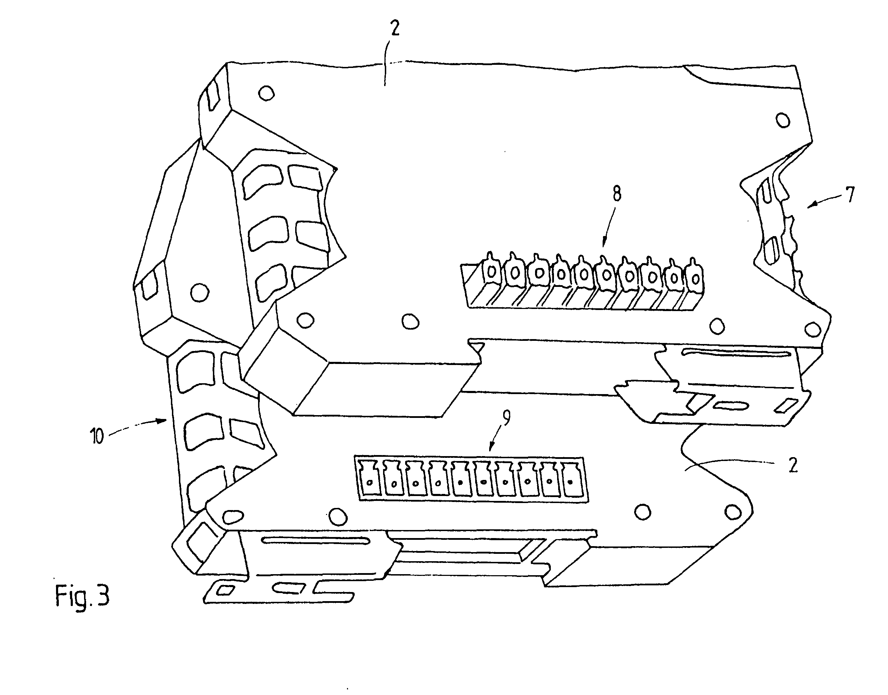

Wie in Figur 3 dargestellt, weisen die Funktionsmodule Ausgänge 9 und Eingänge 8 für das Modulbussystem auf, welche bei den Funktionsmodulen 2 seitens einander gegenüberliegender Gehäuseseiten ausgebildet sind. Die Ausgänge 9 des Bussystems sind dabei bei dem Basismodul 1 als auch bei den Funktionsmodulen 2 als Buchsenleiste ausgebildet, die Eingänge 8 des Bussystems als mit der Buchsenleiste korrespondierende Steckerleiste. Stecker und Buchsen sind dabei als Stecksystem ausgebildet, die ein lösbares Verbinden von Funktionsmodulen 2 untereinander oder Funktionsmodulen 2 mit dem Basismodul 1 durch Aneinanderstecken ermöglichen. So lässt sich das Schaltgerätesystem aus einem Basismodul 1 und mehreren Funktionsmodulen 2 gemäß Figur 1 ausbilden. Über das Modulbussystem, gegeben durch die Ausgänge 9 seitens des Basismoduls 1 bzw. der Funktionsmodule 2 und den Eingängen 8 seitens der Funktionsmodule 2 werden die Funktionsmodule 2 von dem Basismodul 1 und der Spannungsversorgung 3 mit Gleichspannung zur Versorgung der Sensorik- und/oder Aktorikelemente versorgt. Darüber hinaus erfolgt über das Modulbussystem die Parametrisierung der Funktionsmodule 2 in Abhängigkeit der seitens des Mikrocontrollers der Busanschlußeinrichtung des Basismoduls 1 vorgesehenen Applikationen. Dabei werden die Funktionalitäten der Funktionsmodule 2 seitens des Basismoduls 1 automatisiert erkannt. Gleichzeitig wird durch das Schaltgerätesystem der Installationsbus zum Betreiben der Sensorik- und/oder Aktorikelemente bereitgestellt.

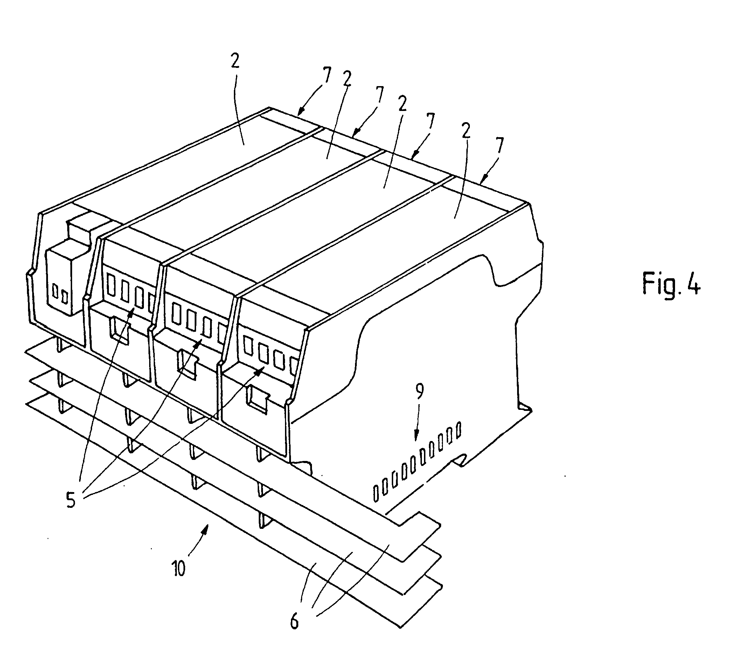

Zur Vereinfachung der Installation des Schaltgerätesystems in einem Schaltschrank werden den Funktionsmodulen 2 zur Energieversorgung von zu steuernden elektrischen Verbrauchsmitteln im Bereich der eingangsseitigen Energieversorgungsanschlüsse 5 von Sicherungselementen herkommend Energieversorgungsleitungen mit steckbaren und gegeneinander isolierten Stromschienen 6, gemäß Figur 4 entsprechend einem Ein-Phasen-Wechselstromnetzwerk über drei Leitungen, zugeführt, welche in Öffnungen 10 der Module steckbar befestigbar sind. Damit ist der Verdrahtungsaufwand bei der Installation des Schaltgerätesystems auf ein Minimum reduziert.

Die in den Figuren beschriebenen Ausführungsbeispiele dienen lediglich der Erläuterung der Erfindung und sind für diese nicht beschränkend.

### Bezugszeichenliste

- 1: Basismodul
- 2: Funktionsmodul
- 3: Spannungsversorgung
- 4: Hutprofilschiene
- 5: Energieversorgungsanschluss (eingangsseitig)
- 6: Stromschiene (Energieversorgung)
- 7: Energieversorgungsanschluss (ausgangsseitig)
- 8: Bussystem (Eingang/Stecker)
- 9: Bussystem (Ausgang/Buchse)
- 10: Öffnung (steckbare Befestigung Stromschiene 6)

## Patentansprüche

1. Schaltgerätesystem zum zentralen Einbau in einem Schaltschrank bzw. Verteilergehäuse für Elektroinstallationen für im Bereich der Gebäudesystemtechnik an einem Installationsbus betreibbare Sensorik- und/oder Aktorikelemente zum Steuern von elektrischen Verbrauchsmitteln, mit einem eine (Busanschlußeinrichtung) BCU und einen ein Bussystem bereitstellenden Ausgang (9) aufweisenden Basismodul (1) zur Parametrisierung von Funktionsmodulen (2) und wenigstens einem einen Installationsbusanschluss zur Kommunikation mit Sensorik- und/oder Aktorikelementen und zur Energieversorgung der Sensorik- und/oder Aktorikelemente, einen eingangsseitigen und wenigstens einen ausgangsseitigen Energieversorgungsanschluss (5, 7) zur Energieversorgung von zu steuernden elektrischen Verbrauchsmitteln, wenigstens einen Schaltkontakt zum Verbinden oder Trennen des eingangsseitigen und wenigstens eines ausgangsseitigen Energieversorgungsanschlusses (5, 7) und einen Eingang (8) und einen Ausgang (9) für das vom Basismodul (1) bereitgestellte Bussystem aufweisenden Funktionsmodul (2), wobei das Basismodul (1) und das wenigstens eine Funktionsmodul (2) über das Bussystem miteinander kommunizieren und Ausgang (9) und Eingang (8) des Bussystems der Module (1, 2) ein Stecksystem zum lösbaren Verbinden der Module zu einer Einheit bereitstellen und wobei die Funktionsmodule (2) über das interne Bussystem von dem Basismodul (1) automatisch adressiert werden.

2. Schaltgerätesystem nach Anspruch 1, **dadurch gekennzeichnet, daß** das Funktionsmodul (2) einen Mikrocontroller zur Funktionsrealisierung des Schaltkontakts und zur Steuerung der Kommunikation mit dem Basismodul (1) über das interne Bussystem sowie mit zugeordneten Sensorik- und/oder Aktorikelementen über den Installationsbus aufweist.

3. Schaltgerätesystem nach Anspruch 1 oder Anspruch 2, **dadurch gekennzeichnet, daß** die Energieversorgungsanschlüsse (5, 7) der Funktionsmodule (2) als integrierte Anschlussklemmen vorzugsweise für Außenleiter (L), Neutralleiter (N) und Schutzleiter (PE), ausgebildet sind.

4. Schaltgerätesystem nach Anspruch 3, **dadurch gekennzeichnet, daß** die Energieversorgungsanschlüsse (5, 7) mit trennbaren Anschlussklemmen für Neutralleiter (N) ausgebildet sind.

5. Schaltgerätesystem nach Anspruch 3 oder Anspruch 4, **dadurch gekennzeichnet, daß** die Anschlussklemmen für Leiterquerschnitte bis 2,5 mm² ausgelegt sind.

6. Schaltgerätesystem nach einem der Ansprüche 1 bis 5, **dadurch gekennzeichnet, daß** die eingangsseitige Energieversorgung (5) über steckbare, von einander isolierte Stromschienen (6) erfolgt, welche vorzugsweise in im Bereich der eingangsseitigen Energieversorgungsanschlüsse (5) der Funktionsmodule (2) ausgebildete Öffnungen (10) einsteckbar und befestigbar sind.

7. Schaltgerätesystem nach einem der Ansprüche 1 bis 6, **dadurch gekennzeichnet, daß** der Installationsbus ein European Installation Bus ist.

8. Schaltgerätesystem nach einem der Ansprüche 1 bis 7, **dadurch gekennzeichnet, daß** die Busanschlußeinrichtung des Basismoduls (1) einen Mikrocontroller aufweist.

9. Schaltgerätesystem nach einem der Ansprüche 1 bis 8, **gekennzeichnet durch** ein Spannungsversorgungsmodul (3) zur Energieversorgung des Basismoduls (1) vorzugsweise über das Bussystem und der Funktionsmodule (2) galvanisch entkoppelt im Basismodul (1) über eine interne Verbindung.

## Claims

1. Switching system for central installation in a switch box or distributor housing for electrical installations for sensor and/or actuator elements which can be operated on an installation bus in the field of buildings systems technology for the control of electrical consumers, with a base module (1) having a bus connection unit (BCU) and an output (9) providing a bus system for parameterising functional modules (2) and with at least one functional module (2) having an installation bus connection for communication with sensor and/or actuator elements and for power supply to the sensor and/or actuator elements, a power supply connection (5, 7) on the input side and at least one such connection on the output side for power supply to electrical consumers which are to be controlled, at least one switch contact for connection or disconnection of the power supply connection (5, 7) on the input side and the at least one such connection on the output side, and an input (8) and an output (9) for the bus system provided by the base module (1), wherein the base module (1) and the at least one functional module (2) communicate with one another via the bus system and the output (9) and input (8) of the bus system of the modules (1, 2) provide a plug system for releasable connection of the modules to form one unit, and wherein the functional modules (2) are automatically addressed by the base module (1) via the internal bus system.

2. Switching system as claimed in Claim 1, **characterised in that** the functional module (2) has a microcontroller for carrying out the function of the switch contact and for controlling the communication with the base module (1) via the internal bus system as well as with associated sensor and/or actuator elements via the installation bus.

3. Switching system as claimed in Claim 1 or Claim 2, **characterised in that** the power supply connections (5, 7) of the functional modules are designed as integrated connecting terminals preferably for outer conductor (L), neutral conductor (N) and protective conductor (PE).

4. Switching system as claimed in Claim 3, **characterised in that** the power supply connections (5, 7) are constructed with disconnectable connecting terminals for the neutral conductor (N).

5. Switching system as claimed in Claim 3 or Claim 4, **characterised in that** the connecting terminals are designed for conductor cross-sections up to 2.5 mm².

6. Switching system as claimed in any one of Claims 1 to 5, **characterised in that** the power supply (5) on the input side takes place via plug-in busbars (6) which are insulated from one another and which can preferably be inserted and fixed in openings (10) constructed in the region of the power supply connections (5) on the input side.

7. Switching system as claimed in any one of Claims 1 to 6, **characterised in that** the installation bus is a European installation bus.

8. Switching system as claimed in any one of Claims 1 to 7, **characterised in that** the bus connection unit of the base module (1) has a microcontroller.

9. Switching system as claimed in any one of Claims 1 to 8, **characterised by** a voltage supply module (3) for power supply to the base module (1) preferably via the bus system and to the functional modules (2) galvanically decoupled in the base module (1) via an internal connection.

## Revendications

1. Ensemble d'interrupteurs destiné à un montage central dans une armoire électrique ou un boîtier de distribution pour des installations électriques, pour des éléments de détection et/ou d'actionnement pouvant être commandés sur un bus d'installation pour la commande de consommateurs électriques dans le domaine de la domotique, avec une unité BCU (unité de connexion au bus) et un module de base (1) possédant une sortie (9) qui forme un système de bus pour le paramétrage de modules fonctionnels (2) et au moins une connexion au bus d'installation pour la communication avec les éléments de détection et/ou d'actionnement et pour l'alimentation en énergie des éléments de détection et/ou d'actionnement, un branchement d'alimentation en énergie (5, 7) du côté de l'entrée et au moins un du côté de la sortie pour l'alimentation en énergie de consommateurs électriques à commander, au moins un contact de commutation pour le raccordement ou la séparation du branchement d'alimentation en énergie (5, 7) du côté de l'entrée et du au moins un branchement d'alimentation en énergie du côté de la sortie, et une entrée (8) et une sortie (9) pour le module fonctionnel (2) présentant le système de bus formé par le module de base (1), le module de base (1) et le au moins un module fonctionnel (2) communiquant entre eux sur le système de bus et la sortie (9) et l'entrée (8) du système de bus des modules (1, 2) constituant un système de raccordement pour l'assemblage amovible des modules de façon à former une unité, et les modules fonctionnels (2) étant automatiquement adressés par le module de base (1) sur le système de bus interne.

2. Ensemble d'interrupteurs selon la revendication 1, **caractérisé en ce que** le module fonctionnel (2) possède un microcontrôleur pour la réalisation des fonctions des contacts de commutation et pour la commande de la communication avec le module de base (1) via le système de bus interne ainsi qu'avec les éléments de détection et/ou d'actionnement correspondants par l'intermédiaire du bus d'installation.

3. Ensemble d'interrupteurs selon la revendication 1 ou 2, **caractérisé en ce que** les branchements d'alimentation en énergie (5, 7) des modules fonctionnels (2) sont conçus comme des bornes de raccordement intégrées, de préférence pour des conducteurs extérieurs (L), des conducteurs neutres (N) et des conducteurs de protection (PE).

4. Ensemble d'interrupteurs selon la revendication 3, **caractérisé en ce que** les branchements d'alimentation en énergie (5, 7) sont pourvus de bornes de raccordement sectionnables pour les conducteurs neutres (N).

5. Ensemble d'interrupteurs selon la revendication 3 ou 4, **caractérisé en ce que** les bornes de raccordement sont conçues pour des sections de conducteurs de 2,5 mm² au maximum.

6. Ensemble d'interrupteurs selon l'une quelconque des revendications 1 à 5, **caractérisé en ce que** l'alimentation en énergie du côté de l'entrée (5) passe par des barres conductrices (6) isolées les unes des autres, qui peuvent être insérées et fixées de préférence dans des ouvertures (10) formées au niveau des raccords d'alimentation en énergie du côté de l'entrée (5) des modules fonctionnels (2).

7. Ensemble d'interrupteurs selon l'une quelconque des revendications 1 à 6, **caractérisé en ce que** le bus d'installation est un bus EIB.

8. Ensemble d'interrupteurs selon l'une quelconque des revendications 1 à 7, **caractérisé en ce que** l'unité de raccordement au bus du module de base (1) possède un microcontrôleur.

9. Ensemble d'interrupteurs selon l'une quelconque des revendications 1 à 8, **caractérisé en ce qu'**il comprend un module d'alimentation en tension (3) pour l'alimentation en énergie du module de base (1) de préférence par l'intermédiaire du système de bus, et pour l'alimentation des modules fonctionnels (2) par un branchement interne, avec découplage galvanique dans le module de base (1).
